# EUROPEAN PATENT SPECIFICATION

(11) **EP 3 467 873 B1**
(45) Date of publication and mention of the grant of the patent: **22.04.2020**
(21) Application number: 18196190.5
(22) Date of filing: 24.09.2018
(51) Int. Cl.: H01L 23/373, H01L 23/495, H01L 25/11, H01L 23/433

(54) **SEMICONDUCTOR DEVICE**
HALBLEITERBAUELEMENT
DISPOSITIF À SEMICONDUCTEUR

(30) Priority: 02.10.2017 JP 2017192740
(43) Date of publication of application: 10.04.2019
(73) Proprietor: TOYOTA JIDOSHA KABUSHIKI KAISHA, Toyota-shi, Aichi-ken, 471-8571 (JP)
(72) Inventor: TSUCHIMOCHI, Shingo, TOYOTA-SHI, AICHI-KEN, 471-8571 (JP)
(74) Representative: Cabinet Beau de Loménie

(56) References cited:
- US-A1- 2011 037 166

## Description

### BACKGROUND OF THE INVENTION

### 1. Field of the Invention

The present disclosure relates to a semiconductor device.

### 2. Description of Related Art

Japanese Unexamined Patent Application Publication No. 2012-146760 (JP 2012-146760 A) discloses a semiconductor device using an insulating substrate. The insulating substrate is a substrate mainly used in a power system circuit. For example, the insulating substrate has a structure in which a metal layer formed of copper, aluminum, or the like is provided on both surfaces of an insulating layer formed of ceramic. The semiconductor device described in JP 2012-146760 A includes an insulating substrate, a semiconductor element provided on a first metal layer, and an external connection terminal bonded to the same metal layer. US2011037166 discloses a semiconductor device and semiconductor device manufacturing methods.

### SUMMARY OF THE INVENTION

In the insulating substrate, since the linear expansion coefficients of the insulating layer and the metal layer are different, thermal stress tends to occur with a temperature change. The thermal stress that may occur in the insulating substrate increases with the size of the insulating substrate. Accordingly, in order to suppress damage to the insulating substrate caused by the thermal stress, it is conceivable to reduce the size of the insulating substrate. However, in order to electrically connect the semiconductor element and the external connection terminal to each other as in the semiconductor device described above, it is needed to provide the semiconductor element for the same metal layer of the insulating substrate and bond the external connection terminal to the same metal layer of the insulating substrate. In this case, the area needed for the metal layer becomes relatively large. Therefore, since it is needed to adopt an insulating substrate having a relatively large size, the thermal stress that may occur in the insulating substrate also increases.

The present disclosure provides a semiconductor device capable of reducing thermal stress that may occur in an insulating substrate.

An aspect of the present disclosure relates to a semiconductor device including an insulating substrate, a semiconductor element, and an external connection terminal, according to claim 1. The insulating substrate includes an insulating layer of which a first metal layer and a second metal layer are provided on both surfaces. The semiconductor element is provided on the first metal layer. The external connection terminal is bonded to the first metal layer and is electrically insulated from the second metal layer. The first metal layer includes a main portion and a protruding portion. The main portion being in contact with the insulating layer, and the semiconductor element is provided in the main portion. The protruding portion protrudes from the main portion, and the external connection terminal is bonded to the protruding portion. At least a part of the protruding portion is provided to protrude from an outer peripheral edge of the insulating layer in a plan view of the insulating substrate.

In the semiconductor device according to the aspect of the present disclosure, the semiconductor element is provided on the same metal layer of the insulating substrate as the external connection terminal which is bonded to the same metal layer of the insulating substrate. As described above, the semiconductor element is electrically connected to the external connection terminal through the metal layer. In the metal layer, it is needed to provide a region where the semiconductor element is provided and a region where the external connection terminal is bonded. Therefore, the area needed for the metal layer may be relatively large. However, the protruding portion is provided in the metal layer and the external connection terminal is bonded to the protruding portion. According to the configuration described above, the area of the insulating layer may be made relatively smaller than the area needed for the metal layer. By reducing the area of the insulating layer, thermal stress occurring in the insulating substrate may be effectively reduced.

In the semiconductor device according to aspects of the present disclosure, the protruding portion is located to be spaced apart from the outer peripheral edge of the insulating layer. According to the configuration described above, even in a case where the protruding portion protrudes from the outer peripheral edge of the insulating layer, insulation between the metal layers may be maintained by making a creepage distance between metal layers, which are located on both surfaces of the insulating layer, relatively long. The creepage distance referred to herein means the length of the shortest path from the first metal layer to the second metal layer along the surface of the insulating layer.

In the semiconductor device according to aspects of the present disclosure, the protruding portion may protrude from a peripheral side surface of the main portion. According to the configuration described above, the protruding portion protruding from the outer peripheral edge of the insulating layer may be formed in a relatively small size. However, as another embodiment, the protruding portion may be provided to protrude from the upper surface of the main portion or the like.

In the semiconductor device according to aspects of the present disclosure, the protruding portion may extend along a direction parallel to the insulating layer. According to the configuration described above, the protruding portion protruding from the outer peripheral edge of the insulating layer may be formed in a smaller size. However, as another embodiment, a part or the whole of the protruding portion may extend along a direction forming an angle with the insulating layer.

In the semiconductor device according to aspects of the present disclosure, in a section of at least a part between a base end and a distal end of the protruding portion, a sectional area of the protruding portion may increase toward the base end. According to the configuration described above, the mechanical strength of the protruding portion may be increased.

In aspects of the present disclosure, a contact area between the insulating layer and the second metal layer may be larger than a contact area between the insulating layer and the first metal layer. According to the configuration described above, it is possible to improve the heat dissipation performance of the insulating substrate while maintaining the creepage distance between the metal layers located on both surfaces of the insulating layer.

In the semiconductor device according to aspects of the present disclosure, a contact area between the insulating layer and the first metal layer may be larger than a contact area between the insulating layer and the second metal layer. According to the configuration described above, it is possible to increase the degree of freedom relevant to the arrangement of the semiconductor element while maintaining the creepage distance between the metal layers located on both surfaces of the insulating layer.

In aspects of the present disclosure, a contact area between the insulating layer and the first metal layer may be equal to a contact area between the insulating layer and the second metal layer. According to the configuration described above, since the thermal stress received from the metal layers located on both surfaces of the insulating layer is balanced, the thermal stress acting on the insulating layer is reduced.

The semiconductor device according to aspects of the present disclosure may further include an insulating sealing body configured to seal the semiconductor element. The first metal layer may be located inside the sealing body, and the second metal layer may be exposed to a surface of the sealing body. According to the configuration described above, the semiconductor element is protected by the sealing body, and the heat of the semiconductor element is easily dissipated to the outside through the insulating substrate.

In the semiconductor device according to aspects of the present disclosure, the insulating substrate may be a direct bonded copper (DBC) substrate. The DBC substrate is also referred to as a direct copper bonding (DCB) substrate.

### BRIEF DESCRIPTION OF THE DRAWINGS

Features, advantages, and technical and industrial significance of exemplary embodiments of the invention will be described below with reference to the accompanying drawings, in which like numerals denote like elements, and wherein:
FIG. 1 is a plan view of a semiconductor device of an embodiment;
FIG. 2 shows the internal structure of the semiconductor device of the embodiment of FIG. 1;
FIG. 3 is a sectional view taken along the line III - III in FIG. 1;
FIG. 4 is a sectional view taken along the line IV-IV in FIG. 1;
FIG. 5 shows a main part of a lower insulating substrate having a protruding portion;
FIG. 6A is a diagram illustrating a modification example of the lower insulating substrate, in particular, a modification example of a structure relevant to the protruding portion;
FIG. 6B is a diagram illustrating a modification example of the lower insulating substrate, in particular, a modification example of a structure relevant to the protruding portion;
FIG. 7A is a diagram illustrating a modification example of a lower insulating substrate, in particular, a modification example relevant to the contact area of a metal layer;
FIG. 7B is a diagram illustrating a modification example of a lower insulating substrate, in particular, a modification example relevant to the contact area of a metal layer;
FIG. 8A is a diagram illustrating a modification example of a lower insulating substrate, in particular, a modification example relevant to the thickness of a metal layer;
FIG. 8B is a diagram illustrating a modification example of a lower insulating substrate, in particular, a modification example relevant to the thickness of a metal layer;
FIG. 9 shows a semiconductor device disposed between coolers;
FIG. 10A is a diagram illustrating distortion of a solder layer due to thermal expansion of a first conductor spacer;
FIG. 10B is a diagram illustrating distortion of a solder layer due to thermal expansion of a first conductor spacer;
FIG. 11 is a modification example of the semiconductor device of the embodiment of FIG. 1, and shows that a common upper insulating substrate is adopted;
FIG. 12 is a modification example of the semiconductor device of the embodiment of FIG. 1, and shows that a common lower insulating substrate is adopted;
FIG. 13A is a diagram illustrating the structure of the semiconductor device of the embodiment of FIG. 2;
FIG. 13B is a diagram illustrating an example of adoption of the semiconductor device of the embodiment of FIG. 13A;
FIG. 14A is a diagram illustrating the structure of a semiconductor device of another embodiment;
FIG. 14B is a diagram illustrating an example of adoption of the semiconductor device of the embodiment of FIG. 14A;
FIG. 15A is a diagram illustrating the structure of a semiconductor device of another embodiment;
FIG. 15B is a diagram illustrating an example of adoption of the semiconductor device of the embodiment of FIG. 15A;
FIG. 16 is a diagram schematically showing a power unit adopting the semiconductor device of the embodiment; and
FIG. 17 is a diagram schematically showing the structure of a second semiconductor device adopted in a power unit.

### DETAILED DESCRIPTION OF EMBODIMENTS

A semiconductor device 10 of an embodiment will be described with reference to the diagrams. The semiconductor device 10 of the present embodiment may be used for electric power conversion circuits, such as converters and inverters, in electric vehicles, hybrid vehicles, fuel cell vehicles, and the like. However, the application of the semiconductor device 10 is not particularly limited. The semiconductor device 10 may be widely adopted for various device and circuits.

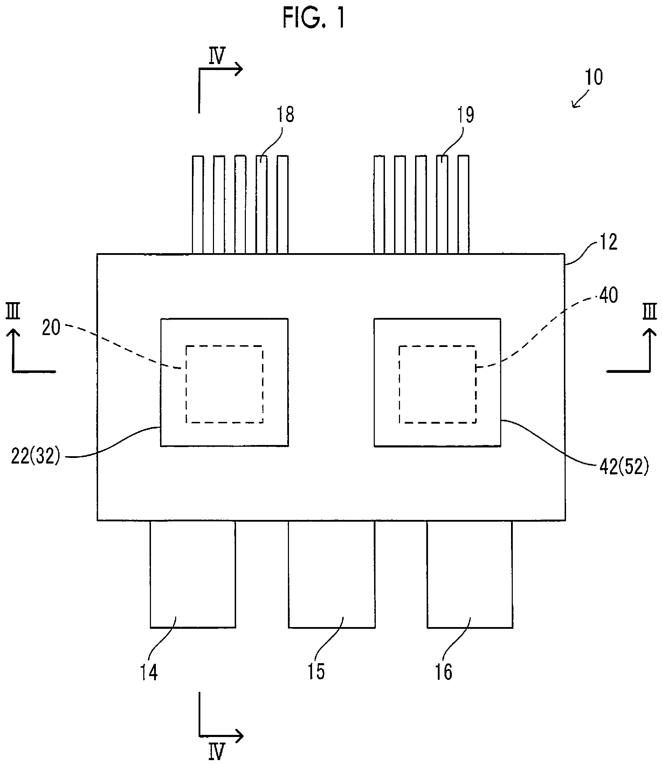

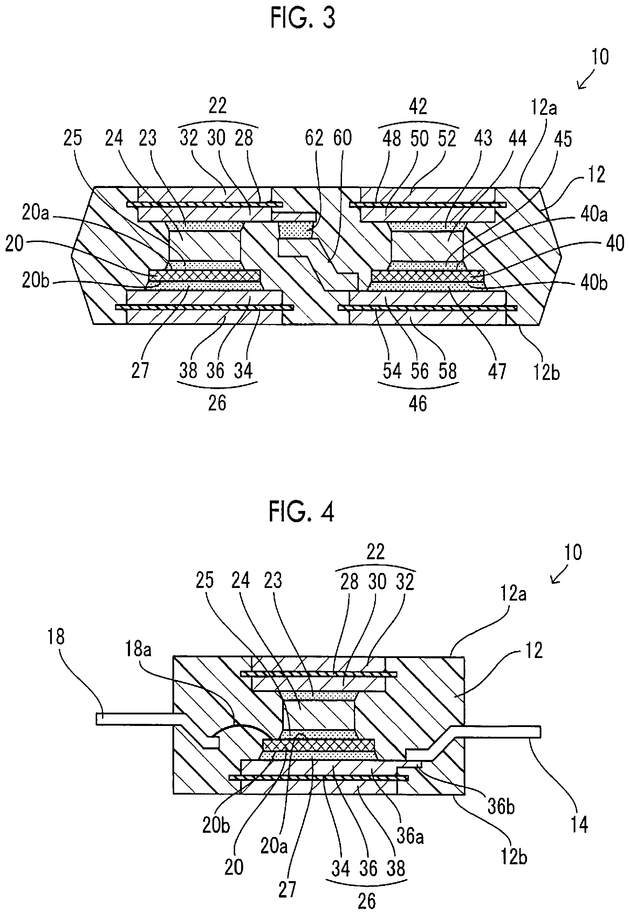

As shown in FIGS. 1 to 4, the semiconductor device 10 includes a first semiconductor element 20, a second semiconductor element 40, a sealing body 12, and a plurality of external connection terminals 14, 15, 16, 18, 19. The first semiconductor element 20 and the second semiconductor element 40 are sealed inside the sealing body 12. Although not particularly limited, the sealing body 12 is formed of, for example, a thermosetting resin, such as an epoxy resin. Each of the external connection terminals 14, 15, 16, 18, 19 extends from the outside to the inside of the sealing body 12, and is electrically connected to at least one of the first semiconductor element 20 and the second semiconductor element 40 in the sealing body 12. As an example, the external connection terminals 14, 15, 16, 18, 19 include a P-terminal 14, an N-terminal 15, and an O-terminal 16 that are terminals for electric power and a plurality of first signal terminals 18 and a plurality of second signal terminals 19 that are terminals for signals.

The first semiconductor element 20 has an upper surface electrode 20a and a lower surface electrode 20b. The upper surface electrode 20a is located on the upper surface of the first semiconductor element 20, and the lower surface electrode 20b is located on the lower surface of the first semiconductor element 20. The first semiconductor element 20 is a vertical semiconductor element having a pair of upper and lower electrodes 20a, 20b. Similarly, the second semiconductor element 40 has an upper surface electrode 40a and a lower surface electrode 40b. The upper surface electrode 40a is located on the upper surface of the second semiconductor element 40, and the lower surface electrode 40b is located on the lower surface of the second semiconductor element 40. That is, the second semiconductor element 40 is also a vertical semiconductor element having a pair of upper and lower electrodes 40a, 40b. In the present embodiment, the first semiconductor element 20 and the second semiconductor element 40 are semiconductor elements of the same type. More specifically, each of the first semiconductor element 20 and the second semiconductor element 40 is a reverse conducting IGBT (RC-IGBT) element having an insulated gate bipolar transistor (IGBT) and a diode.

However, each of the first semiconductor element 20 and the second semiconductor element 40 is not limited to the RC-IGBT element, and may be other power semiconductor elements, such as a metal-oxide-semiconductor field-effect transistor (MOSFET) element. Alternatively, each of the first semiconductor element 20 and the second semiconductor element 40 may be replaced with two or more semiconductor elements, such as a diode element and an IGBT element (or a MOSFET element). The specific configurations of the first semiconductor element 20 and the second semiconductor element 40 are not particularly limited, and various kinds of semiconductor elements may be adopted. In this case, the first semiconductor element 20 and the second semiconductor element 40 may be different types of semiconductor elements. Each of the first semiconductor element 20 and the second semiconductor element 40 may be formed using various kinds of semiconductor materials, such as silicon (Si), silicon carbide (SiC), and gallium nitride (GaN).

The semiconductor device 10 further includes a first upper insulating substrate 22, a first conductor spacer 24, and a first lower insulating substrate 26. The first upper insulating substrate 22 has an insulating layer 28, an inner metal layer 30 provided on one side of the insulating layer 28, and an outer metal layer 32 provided on the other side of the insulating layer 28. The inner metal layer 30 and the outer metal layer 32 are insulated from each other by the insulating layer 28. The inner metal layer 30 of the first upper insulating substrate 22 is electrically connected to the upper surface electrode 20a of the first semiconductor element 20 through the first conductor spacer 24. Although not particularly limited, soldering is adopted for the connection in the present embodiment. Therefore, solder layers 23, 25 are formed between the first upper insulating substrate 22 and the first conductor spacer 24 and between the first conductor spacer 24 and the first semiconductor element 20, respectively.

As an example, the first upper insulating substrate 22 in the present embodiment is a DBC substrate. The insulating layer 28 is formed of ceramic, such as aluminum oxide, silicon nitride, and aluminum nitride, and each of the inner metal layer 30 and the outer metal layer 32 is formed of copper. However, the first upper insulating substrate 22 is not limited to the DBC substrate. The insulating layer 28 is not limited to ceramic, and may be formed of other insulators. The inner metal layer 30 and the outer metal layer 32 are not limited to copper, and may be formed of other metals. The bonding structure between the insulating layer 28 and each of the metal layers 30, 32 is also not particularly limited. The first conductor spacer 24 in the present embodiment is formed of a copper-molybdenum alloy. However, the first conductor spacer 24 is not limited to the copper-molybdenum alloy, and may be formed of other conductors, such as pure copper or other copper alloys.

The first lower insulating substrate 26 has an insulating layer 34, an inner metal layer 36 provided on one side of the insulating layer 34, and an outer metal layer 38 provided on the other side of the insulating layer 34. The inner metal layer 36 and the outer metal layer 38 are insulated from each other by the insulating layer 34. The inner metal layer 36 of the first lower insulating substrate 26 is electrically connected to the lower surface electrode 20b of the first semiconductor element 20. Although not particularly limited, soldering is adopted for the connection in the present embodiment. Therefore, a solder layer 27 is formed between the first semiconductor element 20 and the first lower insulating substrate 26.

As an example, the first lower insulating substrate 26 in the present embodiment is a DBC substrate. The insulating layer 34 is formed of ceramic, such as aluminum oxide, silicon nitride, and aluminum nitride, and each of the inner metal layer 36 and the outer metal layer 38 is formed of copper. However, the first lower insulating substrate 26 is not limited to the DBC substrate. The insulating layer 34 is not limited to ceramic, and may be formed of other insulators. The inner metal layer 36 and the outer metal layer 38 are not limited to copper, and may be formed of other metals. The bonding structure between the insulating layer 34 and each of the metal layers 36, 38 is also not particularly limited.

The outer metal layer 32 of the first upper insulating substrate 22 is exposed to an upper surface 12a of the sealing body 12. As described above, the first upper insulating substrate 22 not only forms a part of the electric circuit of the semiconductor device 10, but also functions as a heat dissipation plate that mainly dissipates the heat of the first semiconductor element 20 to the outside. Similarly, the outer metal layer 38 of the first lower insulating substrate 26 is exposed to a lower surface 12b of the sealing body 12. As described above, the first lower insulating substrate 26 not only forms a part of the electric circuit of the semiconductor device 10, but also functions as a heat dissipation plate that mainly dissipates the heat of the first semiconductor element 20 to the outside. As described above, the semiconductor device 10 of the present embodiment has a double-sided cooling structure in which the outer metal layers 32, 38 are exposed to the upper and lower surfaces 12a, 12b of the sealing body 12.

The semiconductor device 10 further includes a second upper insulating substrate 42, a second conductor spacer 44, and a second lower insulating substrate 46. The second upper insulating substrate 42 has an insulating layer 48, an inner metal layer 50 provided on one side of the insulating layer 48, and an outer metal layer 52 provided on the other side of the insulating layer 48. The inner metal layer 50 and the outer metal layer 52 are insulated from each other by the insulating layer 48. The inner metal layer 50 of the second upper insulating substrate 42 is electrically connected to the upper surface electrode 40a of the second semiconductor element 40 through the second conductor spacer 44. Although not particularly limited, soldering is adopted for the connection in the present embodiment. Therefore, solder layers 43, 45 are formed between the second upper insulating substrate 42 and the second conductor spacer 44 and between the second conductor spacer 44 and the second semiconductor element 40, respectively.

As an example, the second upper insulating substrate 42 in the present embodiment is a DBC substrate. The insulating layer 48 is formed of ceramic, such as aluminum oxide, silicon nitride, and aluminum nitride, and each of the inner metal layer 50 and the outer metal layer 52 is formed of copper. However, the second upper insulating substrate 42 is not limited to the DBC substrate. The insulating layer 48 is not limited to ceramic, and may be formed of other insulators. The inner metal layer 50 and the outer metal layer 52 are not limited to copper, and may be formed of other metals. The bonding structure between the insulating layer 48 and each of the metal layers 50, 52 is also not particularly limited. The second conductor spacer 44 in the present embodiment is formed of a copper-molybdenum alloy. However, the second conductor spacer 44 is not limited to the copper-molybdenum alloy, and may be formed of other conductors, such as pure copper or other copper alloys.

The second lower insulating substrate 46 has an insulating layer 54, an inner metal layer 56 provided on one side of the insulating layer 54, and an outer metal layer 58 provided on the other side of the insulating layer 54. The inner metal layer 56 and the outer metal layer 58 are insulated from each other by the insulating layer 54. The inner metal layer 56 of the second lower insulating substrate 46 is electrically connected to the lower surface electrode 40b of the second semiconductor element 40. Although not particularly limited, soldering is adopted for the connection in the present embodiment. Therefore, a solder layer 47 is formed between the second semiconductor element 40 and the second lower insulating substrate 46.

As an example, the second lower insulating substrate 46 in the present embodiment is a DBC substrate. The insulating layer 54 is formed of ceramic, such as aluminum oxide, silicon nitride, and aluminum nitride, and each of the inner metal layer 56 and the outer metal layer 58 is formed of copper. However, the second lower insulating substrate 46 is not limited to the DBC substrate. The insulating layer 54 is not limited to ceramic, and may be formed of other insulators. The inner metal layer 56 and the outer metal layer 58 are not limited to copper, and may be formed of other metals. The bonding structure between the insulating layer 54 and each of the metal layers 56, 58 is also not particularly limited.

The outer metal layer 52 of the second upper insulating substrate 42 is exposed to the upper surface 12a of the sealing body 12. As described above, the second upper insulating substrate 42 not only forms a part of the electric circuit of the semiconductor device 10, but also functions as a heat dissipation plate that mainly dissipates the heat of the second semiconductor element 40 to the outside. Similarly, the outer metal layer 58 of the second lower insulating substrate 46 is exposed to the lower surface 12b of the sealing body 12. As described above, the second lower insulating substrate 46 not only forms a part of the electric circuit of the semiconductor device 10, but also functions as a heat dissipation plate that mainly dissipates the heat of the second semiconductor element 40 to the outside. As described above, also for the second semiconductor element 40, the semiconductor device 10 of the present embodiment has a double-sided cooling structure in which the outer metal layers 52, 58 are exposed to the upper and lower surfaces 12a, 12b of the sealing body 12.

The semiconductor device 10 further has a joint 60 formed of a conductor. The joint 60 is located inside the sealing body 12, and electrically connects the inner metal layer 30 of the first upper insulating substrate 22 and the inner metal layer 56 of the second lower insulating substrate 46 to each other. As described above, the first semiconductor element 20 and the second semiconductor element 40 are connected in series to each other through the joint 60. As an example, the joint 60 of the present embodiment is formed of copper, and is bonded to the inner metal layer 30 of the first upper insulating substrate 22 through a solder layer 62 and is bonded to the inner metal layer 56 of the second lower insulating substrate 46 by welding.

As described above, the semiconductor device 10 includes the P-terminal 14, the N-terminal 15, and the O-terminal 16 as external connection terminals. The P-terminal 14, the N-terminal 15, and the O-terminal 16 in the present embodiment are formed of copper. However, the P-terminal 14, the N-terminal 15, and the O-terminal 16 are not limited to copper, and may be formed of other conductors. The P-terminal 14 is bonded to the inner metal layer 36 of the first lower insulating substrate 26 in the sealing body 12. The N-terminal 15 is bonded to the inner metal layer 50 of the second upper insulating substrate 42 in the sealing body 12. The O-terminal 16 is bonded to the inner metal layer 56 of the second lower insulating substrate 46. As an example, the P-terminal 14 and the O-terminal 16 are bonded to the inner metal layer 36 of the first lower insulating substrate 26 and the inner metal layer 56 of the second lower insulating substrate 46, respectively, by welding. A range WL shown in the diagrams of this specification indicates a bonding point by welding.

The first signal terminals 18 are connected to the first semiconductor element 20 through bonding wires 18a, and the second signal terminals 19 are connected to the second semiconductor element 40 through bonding wires 19a. The number or specific configurations of the first signal terminal 18 and the second signal terminal 19 are not particularly limited. The semiconductor device 10 does not necessarily need to include the first signal terminal 18 and the second signal terminal 19.

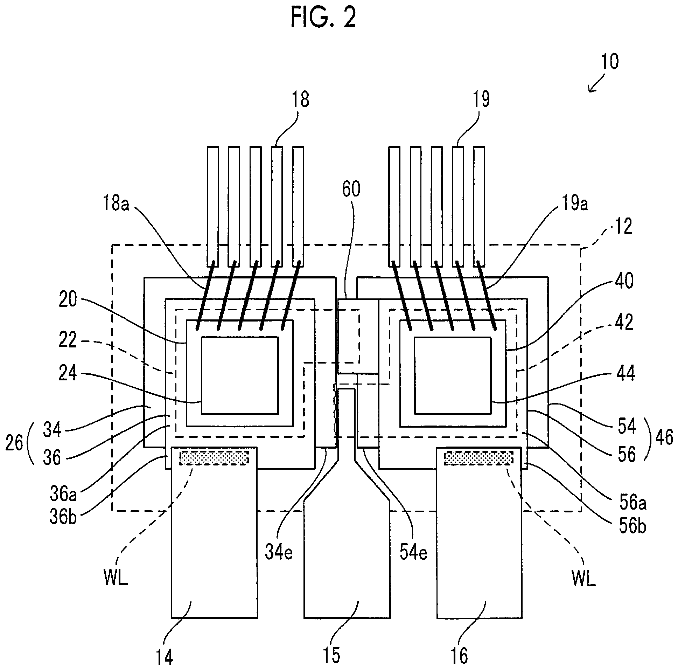

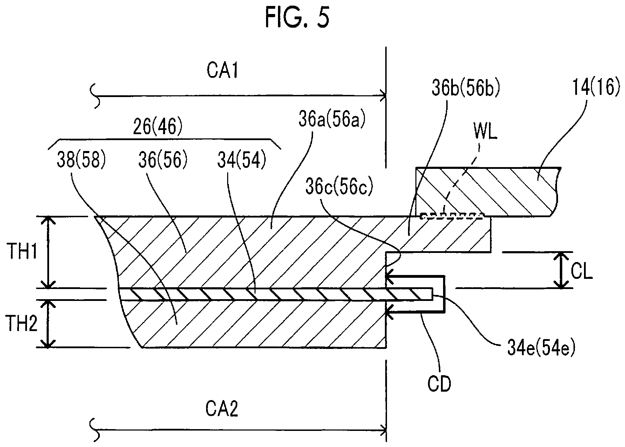

As shown in FIGS. 2 and 5, the inner metal layer 36 of the first lower insulating substrate 26 has a main portion 36a and a protruding portion 36b. The main portion 36a is a portion that spreads while being in contact with the insulating layer 34 of the first lower insulating substrate 26, and the first semiconductor element 20 is provided in the main portion 36a. The protruding portion 36b is a portion protruding from the main portion 36a, and the P-terminal 14 is bonded to the protruding portion 36b. As shown in FIG. 2, in a plan view of the first lower insulating substrate 26, the protruding portion 36b of the inner metal layer 36 protrudes from an outer peripheral edge 34e of the insulating layer 34. The same configuration is also adopted for the inner metal layer 56 of the second lower insulating substrate 46. That is, the inner metal layer 56 of the second lower insulating substrate 46 also has a main portion 56a and a protruding portion 56b. The second semiconductor element 40 is provided in the main portion 56a. The protruding portion 56b is a portion protruding from the main portion 56a, and the O-terminal 16 is bonded to the protruding portion 56b. In a plan view of the second lower insulating substrate 46, the protruding portion 56b of the inner metal layer 56 protrudes from an outer peripheral edge 54e of the insulating layer 54.

In the semiconductor device 10 of the present embodiment, the first semiconductor element 20 is provided on the inner metal layer 36 of the first lower insulating substrate 26, and the P-terminal 14 that is an example of an external connection terminal is bonded to the inner metal layer 36 of the first lower insulating substrate 26. As described above, the first semiconductor element 20 is electrically connected to the P-terminal 14 through the inner metal layer 36. On the other hand, a range where the first semiconductor element 20 is provided and a range where the P-terminal 14 is bonded need to be provided in the inner metal layer 36 of the first lower insulating substrate 26. Therefore, the area needed for the inner metal layer 36 of the first lower insulating substrate 26 may be relatively large. Regarding the above-described point, the protruding portion 36b is provided in the inner metal layer 36 of the first lower insulating substrate 26, and the P-terminal 14 is bonded to the protruding portion 36b.

According to the configuration described above, in the first lower insulating substrate 26, the area of the insulating layer 34 may be made relatively smaller than the area needed for the inner metal layer 36. By reducing the area of the insulating layer 34, thermal stress that may occur in the first lower insulating substrate 26 is effectively reduced. In particular, since the linear expansion coefficient of the insulating layer 34 is smaller than the linear expansion coefficients of the inner metal layer 36 and the outer metal layer 38, tensile stress that may cause breakage tends to occur in the insulating layer 34. By reducing the area of the insulating layer 34, the tensile stress occurring in the insulating layer 34 is reduced. Therefore, damage, such as breakage of the insulating layer 34, may be suppressed. As described above, since the inner metal layer 36 or the outer metal layer 38 may be made relatively thick, the heat dissipation performance of the first lower insulating substrate 26 may be further improved.

Similarly, the protruding portion 56b is provided in the inner metal layer 56 of the second lower insulating substrate 46, and the O-terminal 16 is bonded to the protruding portion 56b. According to the configuration described above, also in the second lower insulating substrate 46, the area of the insulating layer 54 may be made relatively smaller than the area needed for the inner metal layer 56. By reducing the area of the insulating layer 54, thermal stress occurring in the second lower insulating substrate 46 is effectively reduced. In particular, since the linear expansion coefficient of the insulating layer 54 is smaller than the linear expansion coefficients of the inner metal layer 56 and the outer metal layer 58, tensile stress that may cause breakage tends to occur in the insulating layer 54. By reducing the area of the insulating layer 54, the tensile stress occurring in the insulating layer 54 is reduced. Therefore, damage, such as breakage of the insulating layer 54, may be suppressed. As described above, since the inner metal layer 56 or the outer metal layer 58 may be made relatively thick, the heat dissipation performance of the second lower insulating substrate 46 may be further improved.

As shown in FIG. 5, in the first lower insulating substrate 26 in the present embodiment, the protruding portion 36b of the inner metal layer 36 is located to be spaced apart from the outer peripheral edge 34e of the insulating layer 34. According to the configuration described above, even in a case where the protruding portion 36b protrudes from the outer peripheral edge 34e of the insulating layer 34, insulation between the inner metal layer 36 and the outer metal layer 38 may be maintained by making a creepage distance CD between the inner metal layer 36 and the outer metal layer 38, which are located on both surfaces of the insulating layer 34, relatively long. The creepage distance CD referred to herein means the length of the shortest path from the inner metal layer 36 to the outer metal layer 38 along the surface of the insulating layer 34. A space distance CL between the protruding portion 36b and the insulating layer 34 may be designed so as to ensure the needed insulation in consideration of the volume resistivity or the leakage current of the sealing body 12. Similarly, also in the second lower insulating substrate 46, the protruding portion 56b of the inner metal layer 56 is located to be spaced apart from the outer peripheral edge 54e of the insulating layer 54.

In the first lower insulating substrate 26 in the present embodiment, the protruding portion 36b of the inner metal layer 36 protrudes from a peripheral side surface 36c of the main portion 36a. According to the configuration described above, the protruding portion 36b protruding from the outer peripheral edge 34e of the insulating layer 34 may be formed in a relatively small size. In this case, the protruding portion 36b may extend along a direction parallel to the insulating layer 34. As described above, the protruding portion 36b protruding from the outer peripheral edge 34e of the insulating layer 34 may be formed in a smaller size. However, as another embodiment, a part or the whole of the protruding portion 36b may extend along a direction forming an angle with the insulating layer 34. Similarly, also in the second lower insulating substrate 46, the protruding portion 56b of the inner metal layer 56 protrudes from a peripheral side surface 56c of the main portion 56a and extends along a direction parallel to the insulating layer 54.

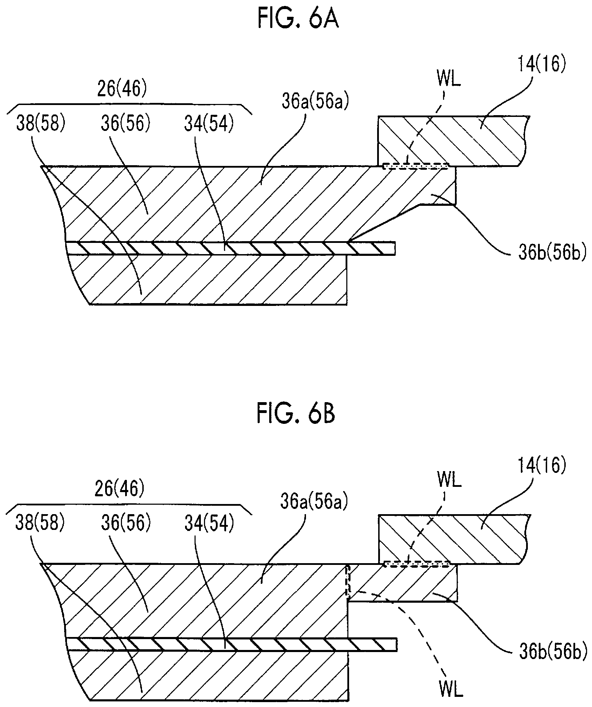

As shown in FIGS. 6A and 6B, in the first lower insulating substrate 26, the configuration of the protruding portion 36b may be variously changed. For example, as shown in FIG. 6A, in a section of at least a part between the base end and the distal end of the protruding portion 36b, the sectional area of the protruding portion 36b may increase toward the base end. According to the configuration described above, the mechanical strength of the protruding portion 36b may be increased. As shown in FIG. 6B, the main portion 36a and the protruding portion 36b may be formed as separate members, and the main portion 36a and the protruding portion 36b may be integrated, for example, by welding. This is also the same for the second lower insulating substrate 46, and the repeated description will be omitted. The configuration relevant to the protruding portions 36b, 56b of the lower insulating substrates 26, 46 may be similarly adopted for a portion bonded to the joint 60 in the inner metal layer 30 of the first upper insulating substrate 22 or a portion bonded to the N-terminal 15 in the inner metal layer 50 of the second upper insulating substrate 42.

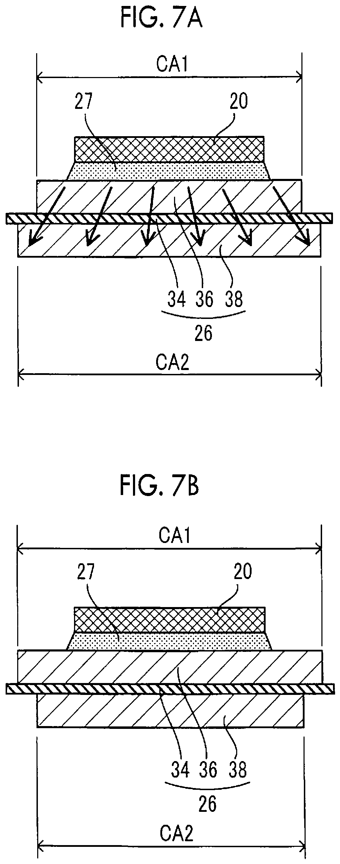

As shown in FIG. 5, in the first lower insulating substrate 26 in the present embodiment, a contact area CA1 between the insulating layer 34 and the inner metal layer 36 is equal to a contact area CA2 between the insulating layer 34 and the outer metal layer 38. According to the configuration described above, since thermal expansion occurring in the inner metal layer 36 and thermal expansion occurring in the outer metal layer 38 are balanced, the thermal stress acting on the insulating layer 34 is reduced. However, as another embodiment, as shown in FIG. 7A, the contact area CA2 between the insulating layer 34 and the outer metal layer 38 may be larger than the contact area CA1 between the insulating layer 34 and the inner metal layer 36. According to the configuration described above, it is possible to improve the heat dissipation performance of the first lower insulating substrate 26 while maintaining the creepage distance CD (refer to FIG. 5) between the inner metal layer 36 and the outer metal layer 38. Alternatively, as shown in FIG. 7B, the contact area CA1 between the insulating layer 34 and the inner metal layer 36 may be larger than the contact area CA2 between the insulating layer 34 and the outer metal layer 38. According to the configuration described above, it is possible to increase the degree of freedom relevant to the arrangement of the first semiconductor element 20 while maintaining the creepage distance CD (refer to FIG. 5) between the inner metal layer 36 and the outer metal layer 38. This is also the same for the second lower insulating substrate 46, and the repeated description will be omitted.

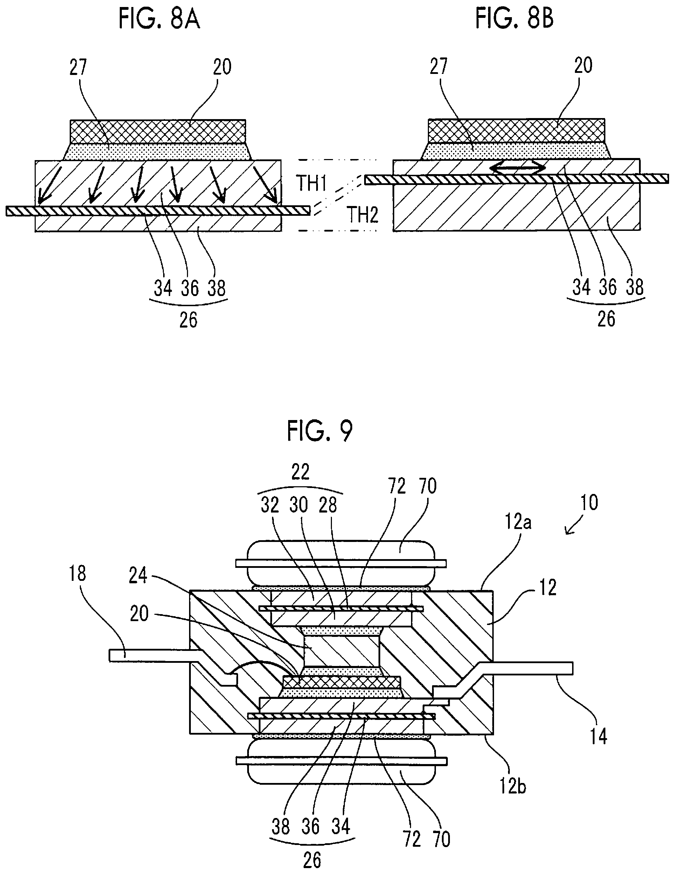

As shown in FIGS. 5 and 8A, in the first lower insulating substrate 26 in the present embodiment, a thickness TH1 of the inner metal layer 36 may be larger than a thickness TH2 of the outer metal layer 38. According to the configuration described above, since the heat capacity of the inner metal layer 36 close to the first semiconductor element 20 is increased, the temperature change of the first semiconductor element 20 may be reduced. However, as another embodiment, as shown in FIG. 8B, the thickness TH2 of the outer metal layer 38 may be larger than the thickness TH1 of the inner metal layer 36. According to the configuration described above, since the thermal expansion of the inner metal layer 36 close to the first semiconductor element 20 is easily suppressed by the insulating layer 34, for example, the thermal stress occurring in the solder layer 27 located between the first semiconductor element 20 and the first lower insulating substrate 26 is suppressed. Alternatively, the thickness TH1 of the inner metal layer 36 may be equal to the thickness TH2 of the outer metal layer 38. According to the configuration described above, since thermal expansion occurring in the inner metal layer 36 and thermal expansion occurring in the outer metal layer 38 are balanced, the thermal stress acting on the insulating layer 34 is reduced.

In the semiconductor device 10 of the present embodiment, the outer metal layers 32, 38, 52, 58 exposed to the upper surface 12a and the lower surface 12b of the sealing body 12 are electrically insulated by the insulating layers 28, 34, 48, 54. Therefore, as shown in FIG. 9, a cooler 70 may be disposed on the upper surface 12a and the lower surface 12b of the sealing body 12 without an insulating plate being interposed therebetween. In this case, a heat dissipation grease 72 may be interposed between the semiconductor device 10 and the cooler 70 as needed. In a case where an insulating plate is disposed between the semiconductor device 10 and the cooler 70, the heat dissipation grease 72 needs to be provided on both surfaces of the insulating plate. That is, two layers of the heat dissipation grease 72 are formed between the semiconductor device 10 and the cooler 70. In contrast to the above, in the semiconductor device 10 of the present embodiment, since there is no need to interpose an insulating plate, solely one layer of the heat dissipation grease 72 is formed between the semiconductor device 10 and the cooler 70. By reducing the number of layers of the heat dissipation grease 72, thermal resistance from the semiconductor device 10 to the cooler 70 is reduced.

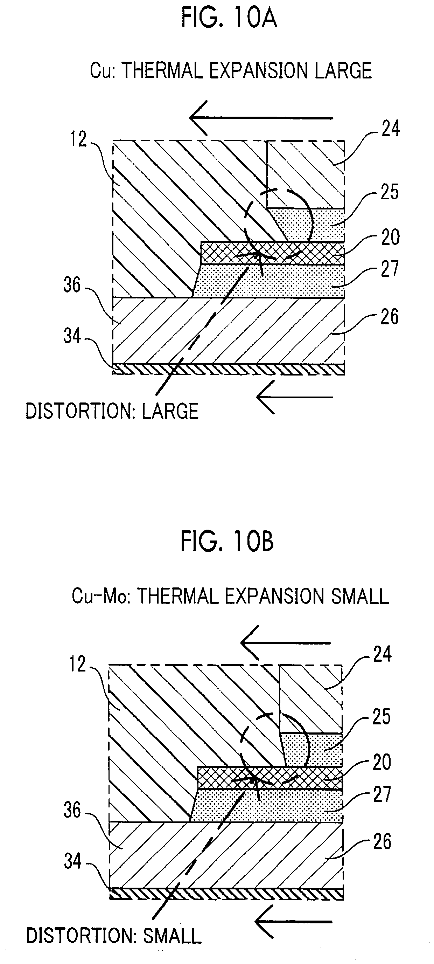

As described above, the first conductor spacer 24 and the second conductor spacer 44 in the present embodiment are formed of a copper-molybdenum alloy. The linear expansion coefficient of the copper-molybdenum alloy is smaller than the linear expansion coefficient of copper forming the inner metal layers 36, 56 and the linear expansion coefficient of the epoxy resin forming the sealing body 12. As described above, in a case where the linear expansion coefficients of the first conductor spacer 24 and the second conductor spacer 44 are smaller than the linear expansion coefficients of the inner metal layers 36, 56 and the linear expansion coefficient of the sealing body 12, distortion occurring in a solder layer 25 located between the first conductor spacer 24 and the first semiconductor element 20 and a solder layer 45 located between the second conductor spacer 44 and the second semiconductor element 40 may be reduced. For example, as shown in FIG. 10A, in a case where the first conductor spacer 24 is formed of copper, the amount of thermal expansion occurring in the first conductor spacer 24 is relatively large. On the other hand, the amount of thermal expansion occurring in the first semiconductor element 20 and the first lower insulating substrate 26 is relatively small. In this case, a relatively large difference occurs in the amount of thermal expansion between the top and bottom of the first semiconductor element 20. As a result, relatively large distortion occurs in the solder layer 25 located between the first conductor spacer 24 and the first semiconductor element 20, causing a problem such as deterioration of the solder layer 25 or damage to the solder layer 25. In contrast to the above, as shown in FIG. 10B, in a case where the first conductor spacer 24 is formed of a material having a small linear expansion coefficient, the amount of thermal expansion occurring on the upper side of the first semiconductor element 20 is reduced. As a result, distortion occurring in the solder layer 25 is suppressed. This is also the same for the second conductor spacer 44. Materials forming the first conductor spacer 24 and the second conductor spacer 44 are not particularly limited. In addition to the copper-molybdenum alloy, for example, a copper-tungsten alloy may be mentioned.

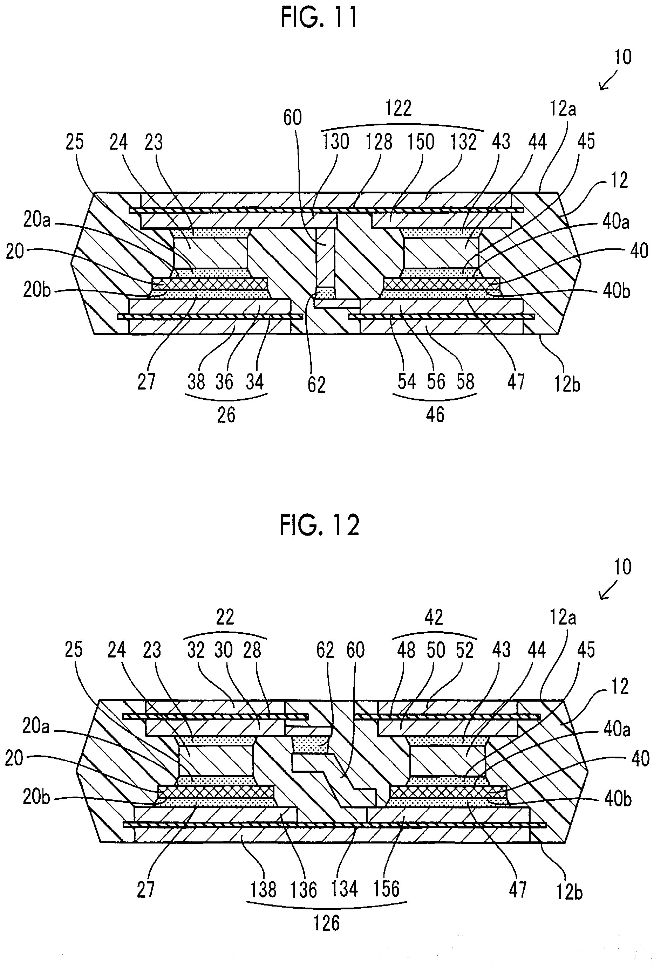

As shown in FIG. 11, in the semiconductor device 10 in the present embodiment, the first upper insulating substrate 22 and the second upper insulating substrate 42 may be changed to a single common upper insulating substrate 122. The common upper insulating substrate 122 has a common insulating layer 128, a first inner metal layer 130 and a second inner metal layer 150 that are provided on one side of the common insulating layer 128, and a common outer metal layer 132 provided on the other side of the common insulating layer 128. The first inner metal layer 130 is connected to the upper surface electrode 20a of the first semiconductor element 20 through the first conductor spacer 24, and the second inner metal layer 150 is connected to the upper surface electrode 40a of the second semiconductor element 40 through the second conductor spacer 44. The joint 60 is integrally formed on the first inner metal layer 130. The common outer metal layer 132 is exposed to the upper surface 12a of the sealing body 12.

In a case where the first upper insulating substrate 22 and the second upper insulating substrate 42 are formed by the single common upper insulating substrate 122, the first inner metal layer 130 or the second inner metal layer 150 may be widely formed. Therefore, for example, the joint 60 may be formed integrally with the first inner metal layer 130. In a case where the joint 60 is formed integrally with the first inner metal layer 130 (namely, the common upper insulating substrate 122), the manufacturing process of the semiconductor device 10 may be simplified.

As shown in FIG. 12, in the semiconductor device 10 in the present embodiment, the first lower insulating substrate 26 and the second lower insulating substrate 46 may be changed to a single common lower insulating substrate 126. The common lower insulating substrate 126 has a common insulating layer 134, a first inner metal layer 136 and a second inner metal layer 156 that are provided on one side of the common insulating layer 134, and a common outer metal layer 138 provided on the other side of the common insulating layer 134. The first inner metal layer 136 is connected to the lower surface electrode 20b of the first semiconductor element 20, and the second inner metal layer 156 is connected to the lower surface electrode 40b of the second semiconductor element 40. The first inner metal layer 136 and the second inner metal layer 156 have the same configuration as the inner metal layer 36 of the first lower insulating substrate 26 and the inner metal layer 56 of the second lower insulating substrate 46 described above (refer to FIG. 5), and have the protruding portions 36b, 56b to which the P-terminal 14 or the O-terminal 16 is bonded.

In a case where the first lower insulating substrate 26 and the second lower insulating substrate 46 are formed by the single common lower insulating substrate 126, the heat dissipation performance of the semiconductor device 10 may be improved. In particular, the first lower insulating substrate 26 and the second lower insulating substrate 46 are close to the first semiconductor element 20 and the second semiconductor element 40, respectively. Since the first lower insulating substrate 26 and the second lower insulating substrate 46 are formed by the common lower insulating substrate 126 having excellent heat dissipation performance, the heat dissipation performance of the semiconductor device 10 is effectively improved.

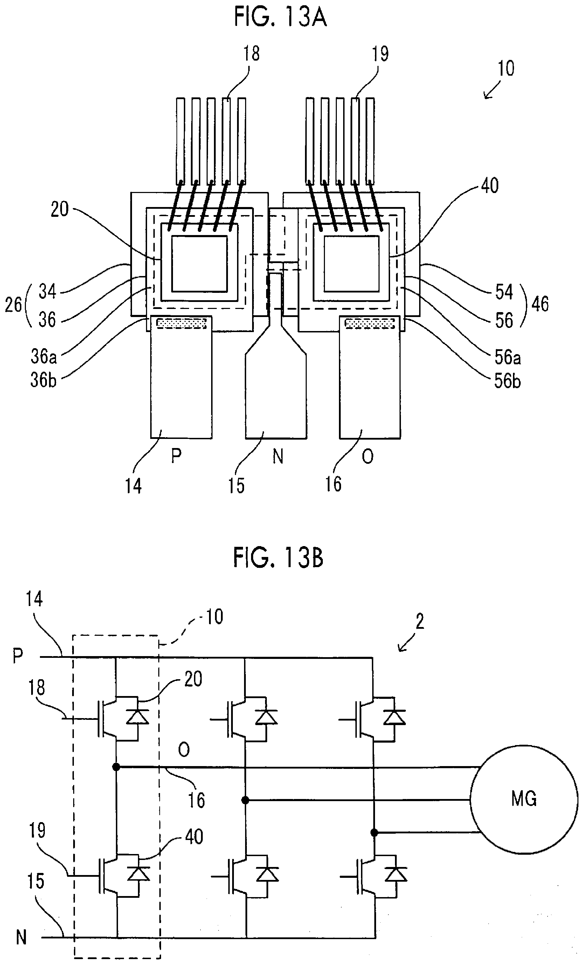

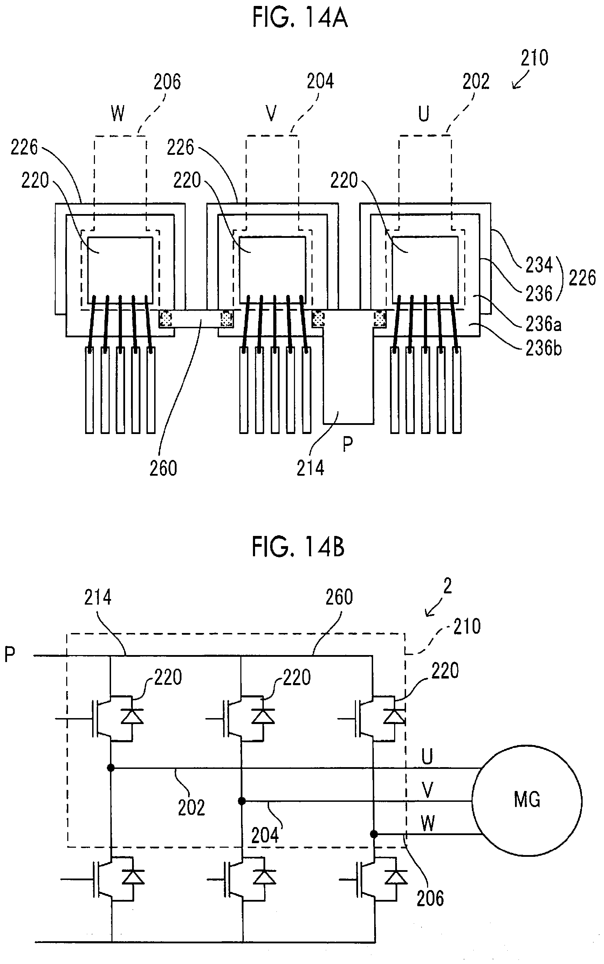

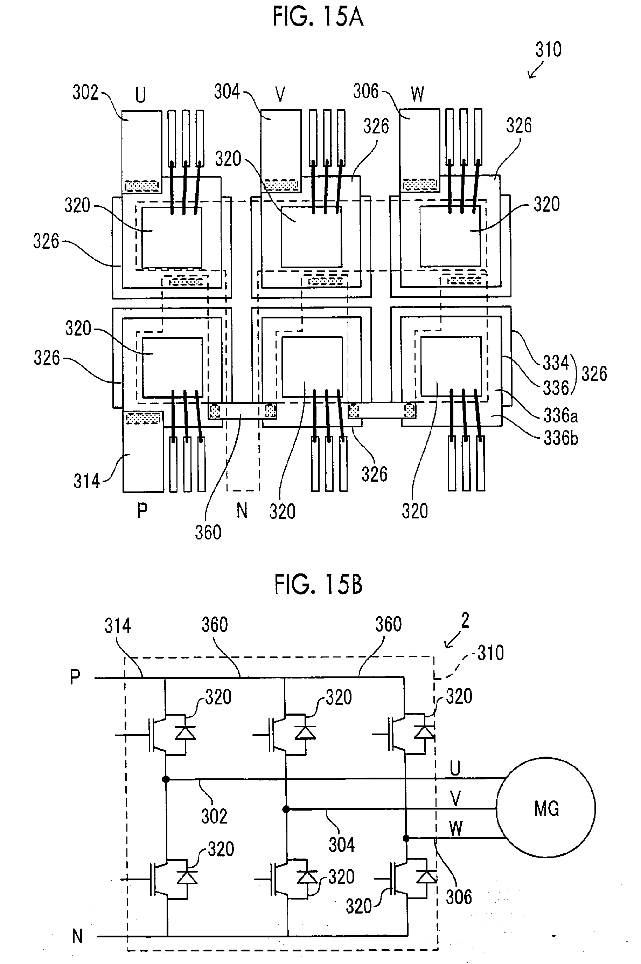

As shown in FIGS. 13A and 13B, the semiconductor device 10 includes two semiconductor elements 20, 40, and has a structure in which the two semiconductor elements 20, 40 are connected in series to each other. Each of the semiconductor elements 20, 40 is an RC-IGBT. Therefore, the semiconductor device 10 may be adopted, for example, as a component forming a pair of upper and lower arms in an inverter circuit 2. However, the present disclosure is not limited to the number of semiconductor elements 20, 40 and the connection structure of the semiconductor elements 20, 40, and may also be applied to various kinds of semiconductor devices 210, 310 shown in FIGS. 14A and 14B and 15A and 15B, for example.

As shown in FIGS. 14A and 14B, a semiconductor device 210 of another embodiment includes three semiconductor elements 220, and each of the semiconductor elements 220 is connected to a P-terminal 214. A U-terminal 202, a V-terminal 204, and a W-terminal 206 are connected to the three semiconductor elements 220, respectively. Each of the semiconductor elements 220 is not particularly limited, and is an RC-IGBT. The semiconductor device 210 may be adopted, for example, as a component forming three upper arms in the inverter circuit 2. The specific configuration of the semiconductor device 210 is not particularly limited. However, the semiconductor device 210 includes three lower insulating substrates 226, and a corresponding one of the three semiconductor elements 220 is provided in each lower insulating substrate 226. Each of the lower insulating substrates 226 has the same configuration as the first lower insulating substrate 26 shown in FIG. 5 and the like, and a main portion 236a and a protruding portion 236b are provided in an inner metal layer 236 located on one side of an insulating layer 234. The semiconductor element 220 is provided in the main portion 236a of the inner metal layer 236, and the P-terminal 214 or a joint 260 is bonded to the protruding portion 236b of the inner metal layer 236. At least two of the three lower insulating substrates 226 may be formed by a single insulating substrate.

As shown in FIGS. 15A and 15B, a semiconductor device 310 of another embodiment includes six semiconductor elements 320, and the semiconductor elements 320 are connected so as to form the inverter circuit 2. Each of the semiconductor elements 320 is not particularly limited, and is an RC-IGBT. According to the semiconductor device 310 described above, the inverter circuit 2 may be solely configured. The specific configuration of the semiconductor device 310 is not particularly limited. However, the semiconductor device 310 includes six lower insulating substrates 326, and a corresponding one of the six semiconductor elements 320 is provided in each lower insulating substrate 326. Each of the lower insulating substrates 326 has the same configuration as the first lower insulating substrate 26 shown in FIG. 5 and the like, and a main portion 336a and a protruding portion 336b are provided in an inner metal layer 336 located on one side of an insulating layer 334. The semiconductor element 320 is provided in the main portion 336a of the inner metal layer 336, and a U-terminal 302, a V-terminal 304, a W-terminal 306, a P-terminal 314, or a joint 360 is bonded to the protruding portion 336b of the inner metal layer 336. At least two of the six lower insulating substrates 326 may be formed by a single insulating substrate.

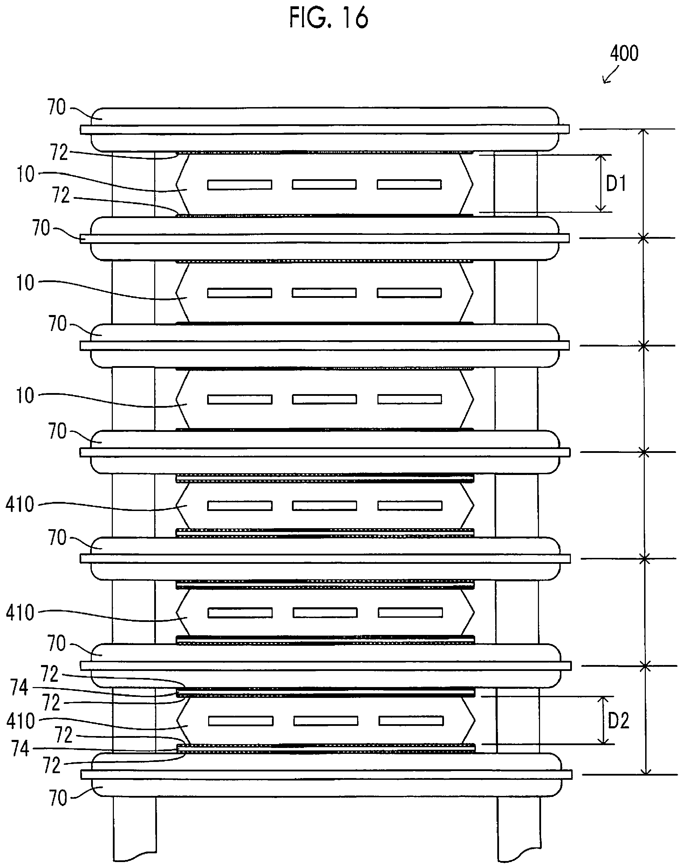

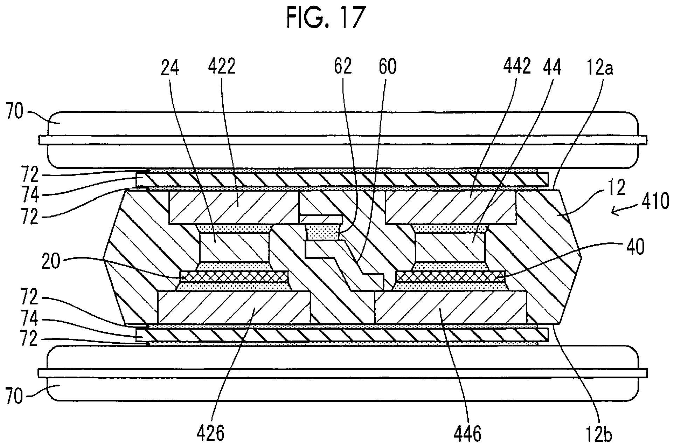

A power unit 400 adopting the semiconductor device 10 of the present embodiment will be described with reference to FIGS. 16 and 17. The power unit 400 includes a plurality of semiconductor devices 10, 410 and a plurality of coolers 70, and the semiconductor devices 10, 410 and the coolers 70 are alternately disposed. In addition to the semiconductor device 10 of the present embodiment, the second semiconductor device 410 is included in the semiconductor devices 10, 410. As shown in FIG. 17, the second semiconductor device 410 has a structure similar to the semiconductor device 10 of the present embodiment. In the second semiconductor device 410, however, compared with the semiconductor device 10 of the present embodiment, four heat dissipation plates 422, 426, 442, 446 are adopted instead of the four insulating substrates 22, 26, 42, 46. The heat dissipation plates 422, 426, 442, 446 are formed of, for example, conductors such as copper, and do not have the insulating layers 28, 34, 48, 54. Therefore, an insulating plate 74 is disposed between the second semiconductor device 410 and the cooler 70, and the second semiconductor device 410 and the cooler 70 are electrically insulated from each other by the insulating plate 74. A layer of the heat dissipation grease 72 is formed on both sides of the insulating plate 74.

As described above, the insulating plate 74 does not need to be disposed between the semiconductor device 10 and the cooler 70 of the present embodiment. In contrast to the above, the insulating plate 74 needs to be disposed between the second semiconductor device 410 and the cooler 70. Therefore, assuming that a thickness D1 of the semiconductor device 10 of the present embodiment is equal to a thickness D2 of the second semiconductor device 410, an interval between the coolers 70 needs to be changed according to the semiconductor devices 10, 410 to be disposed. In this case, the versatility of the coolers 70 is lowered. As described above, in the power unit 400, the thickness D2 of the second semiconductor device 410 is designed to be smaller than the thickness D1 of the semiconductor device 10 of the present embodiment. In addition, as described above, the coolers 70 are disposed at equal intervals. In the power unit 400, a wide band gap semiconductor, such as silicon carbide, is adopted for the semiconductor elements 20, 40 of the semiconductor device 10 of the present embodiment, and silicon is adopted for the semiconductor elements 20, 40 of the second semiconductor device 410. That is, between the semiconductor devices 10, 410, a wide band gap semiconductor is adopted. In addition, in order to suppress the occurrence of relatively large thermal stress, a structure including the insulating layers 28, 34, 48, 54 is adopted.

While some specific examples have been described in detail above, these are merely illustrative and do not limit the scope of the claims. The techniques described in the claims include various changes and modifications of the specific examples described above. The technical elements described in this specification or the diagrams exhibit technical usefulness individually or in various combinations.

## Claims

1. A semiconductor device (10; 210; 310; 410) comprising:
an insulating substrate (22; 42; 26; 46; 122; 126; 226; 326) including an insulating layer (28; 34; 48; 54; 128; 134; 234; 334), a first metal layer and a second metal layer that are provided on both surfaces of the insulating layer;
a semiconductor element (20; 40; 220; 320) provided on the first metal layer; and
an external connection terminal (14; 15; 16; 18; 19) bonded to the first metal layer, the external connection terminal being electrically insulated from the second metal layer,
wherein:
the first metal layer (30;36;50;56;130;150;136;156) includes
a main portion (36a; 56a; 236a; 336a) being in contact with the insulating layer, the semiconductor element being provided in the main portion, and
a protruding portion (36b; 56b; 236b; 336b) protruding from the main portion, the external connection terminal being bonded to the protruding portion;
at least a part of the protruding portion is protruding from an outer peripheral edge (34e; 54e) of the insulating layer in a plan view of the insulating substrate;
the protruding portion (36b; 56b) is located to be spaced apart from the outer peripheral edge (34e; 54e) of the insulating layer (34; 54); **characterised in that**,
there is a space distance (CL) between the protruding portion (36b; 56b) and the insulating layer (34; 54).

2. The semiconductor device (10) according to claim 1, wherein the protruding portion (36b; 56b) protrudes from a peripheral side surface (36c; 56c) of the main portion (36a; 56a).

3. The semiconductor device (10) according to claim 2, wherein the protruding portion (36b; 56b) extends along a direction parallel to the insulating layer (34; 54).

4. The semiconductor device (10) according to any one of claims 1 to 3, wherein, in a section of at least a part between a base end and a distal end of the protruding portion (36b), a sectional area of the protruding portion (36b) increases toward the base end.

5. The semiconductor device (10) according to any one of claims 1 to 4, wherein a contact area (CA2) between the insulating layer (34) and the second metal layer is larger than a contact area (CA1) between the insulating layer (34) and the first metal layer.

6. The semiconductor device (10) according to any one of claims 1 to 4, wherein a contact area (CA1) between the insulating layer (34) and the first metal layer is larger than a contact area (CA2) between the insulating layer (34) and the second metal layer.

7. The semiconductor device (10) according to any one of claims 1 to 4, wherein a contact area (CA1) between the insulating layer (34) and the first metal layer is equal to a contact area (CA2) between the insulating layer (34) and the second metal layer.

8. The semiconductor device (10) according to any one of claims 1 to 7, further comprising an insulating sealing body (12) configured to seal the semiconductor element, wherein:
the first metal layer is located inside the sealing body (12); and
the second metal layer is exposed to a surface of the sealing body (12).

9. The semiconductor device (10) according to any one of claims 1 to 8, wherein the insulating substrate (22; 26; 42; 46) is a direct bonded copper substrate.

## Patentansprüche

1. Halbleitervorrichtung (10; 210; 310; 410), umfassend:
ein Isoliersubstrat (22; 42; 26; 46; 122; 126; 226; 326), das eine Isolierschicht (28; 34; 48; 54; 128; 134; 234; 334), eine erste Metallschicht und eine zweite Metallschicht, die auf beiden Oberflächen der Isolierschicht vorgesehen sind, beinhaltet,
ein Halbleiterelement (20; 40; 220; 320), das auf der ersten Metallschicht vorgesehen ist, und
einen Anschluss (14; 15; 16; 18; 19) zur externen Verbindung, der mit der ersten Metallschicht verbunden ist, wobei der Anschluss zur externen Verbindung von der zweiten Metallschicht elektrisch isoliert ist,
wobei:
die erste Metallschicht (30; 36; 50; 56; 130; 150; 136; 156) beinhaltet
einen Hauptabschnitt (36a; 56a; 236a; 336a), der mit der Isolierschicht in Kontakt steht, wobei das Halbleiterelement in dem Hauptabschnitt vorgesehen ist, und
einen vorstehenden Abschnitt (36b; 56b; 236b; 336b), der von dem Hauptabschnitt vorsteht, wobei der Anschluss zur externen Verbindung mit dem vorstehenden Abschnitt verbunden ist,
wobei in einer Draufsicht auf das Isoliersubstrat zumindest ein Teil des vorstehenden Abschnitts von einer Außenumfangskante (34e; 54e) der Isolierschicht vorsteht,
der vorstehende Abschnitt (36b; 56b) derart angeordnet ist, dass er von der Außenumfangskante (34e; 54e) der Isolierschicht (34; 54) beabstandet ist,
**dadurch gekennzeichnet, dass**
es einen Raumabstand (CL) zwischen dem vorstehenden Abschnitt (36b; 56b) und der Isolierschicht (34; 54) gibt.

2. Halbleitervorrichtung (10) nach Anspruch 1, wobei der vorstehende Abschnitt (36b; 56b) von einer Umfangsseitenfläche (36c; 56c) des Hauptabschnitts (36a; 56a) vorsteht.

3. Halbleitervorrichtung (10) nach Anspruch 2, wobei sich der vorstehende Abschnitt (36b; 56b) entlang einer Richtung parallel zu der Isolierschicht (34; 54) erstreckt.

4. Halbleitervorrichtung (10) nach einem der Ansprüche 1 bis 3, wobei in einer Sektion von zumindest einem Teil zwischen einem Basisende und einem distalen Ende des vorstehenden Abschnitts (36b) eine Querschnittsfläche des vorstehenden Abschnitts (36b) zu dem Basisende hin zunimmt.

5. Halbleitervorrichtung (10) nach einem der Ansprüche 1 bis 4, wobei eine Kontaktfläche (CA2) zwischen der Isolierschicht (34) und der zweiten Metallschicht größer als eine Kontaktfläche (CA1) zwischen der Isolierschicht (34) und der ersten Metallschicht ist.

6. Halbleitervorrichtung (10) nach einem der Ansprüche 1 bis 4, wobei eine Kontaktfläche (CA1) zwischen der Isolierschicht (34) und der ersten Metallschicht größer als eine Kontaktfläche (CA2) zwischen der Isolierschicht (34) und der zweiten Metallschicht ist.

7. Halbleitervorrichtung (10) nach einem der Ansprüche 1 bis 4, wobei eine Kontaktfläche (CA1) zwischen der Isolierschicht (34) und der ersten Metallschicht gleich einer Kontaktfläche (CA2) zwischen der Isolierschicht (34) und der zweiten Metallschicht ist.

8. Halbleitervorrichtung (10) nach einem der Ansprüche 1 bis 7, ferner umfassend einen isolierenden Dichtkörper (12), der dazu ausgestaltet ist, das Halbleiterelement abzudichten, wobei:
die erste Metallschicht sich innerhalb des Dichtkörpers (12) befindet und
die zweite Metallschicht einer Oberfläche des Dichtkörpers (12) ausgesetzt ist.

9. Halbleitervorrichtung (10) nach einem der Ansprüche 1 bis 8, wobei das Isoliersubstrat (22; 26; 42; 46) ein direkt gebondetes Kupfersubstrat ist.

## Revendications

1. Dispositif à semi-conducteur (10 ; 210 ; 310 ; 410) comprenant :
un substrat isolant (22 ; 42 ; 26 ; 46 ; 122 ; 126 ; 226 ; 326) comprenant une couche isolante (28 ; 34 ; 48 ; 54 ; 128 ; 134 ; 234 ; 334), une première couche en métal et une deuxième couche en métal qui sont prévues sur les deux surfaces de la couche isolante ;
un élément de semi-conducteur (20 ; 40 ; 220 ; 320) prévu sur la première couche en métal ; et
une borne de connexion externe (14 ; 15 ; 16 ; 18 ; 19) soudée sur la première couche en métal, la borne de connexion externe étant électriquement isolée de la deuxième couche en métal,
la première couche en métal (30 ; 36 ; 50 ; 56 ; 130 ; 150 ;136 ; 156) comprenant
une partie principale (36a ; 56a ; 236a ; 336a) qui est en contact avec la couche isolante, l'élément de semi-conducteur étant prévu dans la partie principale, et
une partie saillante (36b ; 56b ; 236b ; 336b) faisant saillie de la partie principale, la borne de connexion externe étant soudée sur la partie saillante ;
au moins une partie de la partie saillante fait saillie d'un bord périphérique extérieur (34e ; 54e) de la couche isolante dans une vue en plan du substrat isolant ;
la partie saillante (36b ; 56b) est située de façon à être espacée du bord périphérique extérieur (34e ; 54e) de la couche isolante (34 ; 54) ; **caractérisé en ce que**,
il y a une distance d'espace (CL) entre la partie saillante (36b ; 56b) et la couche isolante (34 ; 54).

2. Dispositif à semi-conducteur (10) selon la revendication 1, dans lequel la partie saillante (36b ; 56b) fait saillie d'une surface latérale périphérique (36c ; 56c) de la partie principale (36a ; 56a).

3. Dispositif à semi-conducteur (10) selon la revendication 2, dans lequel la partie saillante (36b ; 56b) s'étend le long d'une direction parallèle à la couche isolante (34 ; 54).

4. Dispositif à semi-conducteur (10) selon l'une quelconque des revendications 1 à 3, dans lequel, dans une section de au moins une partie entre une extrémité de base et une extrémité distale de la partie saillante (36b), une section de la partie saillante (36b) augmente vers l'extrémité de base.

5. Dispositif à semi-conducteur (10) selon l'une quelconque des revendications 1 à 4, dans lequel une surface de contact (CA2) entre la couche isolante (34) et la deuxième couche en métal est plus grande qu'une surface de contact (CA1) entre la couche isolante (34) et la première couche en métal.

6. Dispositif à semi-conducteur (10) selon l'une quelconque des revendications 1 à 4, dans lequel une surface de contact (CA1) entre la couche isolante (34) et la première couche en métal est plus grande qu'une surface de contact (CA2) entre la couche isolante (34) et la deuxième couche en métal.

7. Dispositif à semi-conducteur (10) selon l'une quelconque des revendications 1 à 4, dans lequel une surface de contact (CA1) entre la couche isolante (34) et la première couche en métal est égale à une surface de contact (CA2) entre la couche isolante (34) et la deuxième couche en métal.

8. Dispositif à semi-conducteur (10) selon l'une quelconque des revendications 1 à 7, comprenant en outre un corps d'étanchéité isolant (12) configuré pour sceller l'élément de semi-conducteur, dans lequel :
la première couche en métal se trouve à l'intérieur du corps d'étanchéité (12) ; et
la deuxième couche en métal est exposée à une surface du corps d'étanchéité (12).

9. Dispositif à semi-conducteur (10) selon l'une quelconque des revendications 1 à 8, dans lequel le substrat isolant (22 ; 26 ; 42 ; 46) est un substrat en cuivre à soudage direct.
